# EUROPEAN PATENT APPLICATION

(11) **EP 4 113 548 A1**
(43) Date of publication of application: **04.01.2023**
(21) Application number: 21761420.5
(22) Date of filing: 26.01.2021
(51) Int. Cl.: H01F 6/06, H01B 12/04

(54) **SUPERCONDUCTING MAGNET, SUPERCONDUCTING WIRE, AND METHOD FOR PRODUCING SUPERCONDUCTING MAGNET**

(30) Priority: 27.02.2020 JP 2020031822
(71) Applicant: Hitachi, Ltd., Tokyo 100-8280 (JP)
(72) Inventor: MIYAMOTO Naoya, Tokyo 100-8280 (JP); WAKUDA Tsuyoshi, Tokyo 100-8280 (JP)
(74) Representative: Strehl Schübel-Hopf & Partner
(86) International application number: PCT/JP2021/002631
(87) International publication number: WO 2021/171872

(57) **Abstract**

Provided is a superconducting magnet at a low cost. The superconducting magnet (100) includes: a magnet portion (1) wound with a first superconducting wire material (50) including a superconducting material portion, a high-resistance conductor layer, and a low-resistance conductor layer having a resistance value per unit length lower than that of the high-resistance conductor layer; and a current switch (30) including a second superconducting wire material (52) including the superconducting material portion and the high-resistance conductor layer. The second superconducting wire material (52) does not include the low-resistance conductor layer or includes the low-resistance conductor layer thinner than the low-resistance conductor layer in the first superconducting wire material (50).

## Description

### Technical Field

The present invention relates to a superconducting magnet, a superconducting wire material, and a production method for a superconducting magnet.

### Background Art

As a background art in this technical field, paragraph 0019 in the description of the following PTL 1 discloses that "a non-connected superconducting wire 1 was wound around a coil bobbin C to manufacture a superconducting coil S1, and a heater wire H was wound around a part of the same wire material. A portion around which the heater wire H was wound was manufactured as a superconducting coil S2 by a non-inductive winding. The superconducting coil S2 is used as a thermal permanent current switch. While the entire superconducting coil is immersed in a refrigerant, a current flows through the heater wire H of the superconducting coil S2 to heat the superconducting coil S2 to a temperature equal to or higher than a superconducting transition temperature, thereby destroying a superconducting state. In this state, the superconducting coil S1 can be excited when power is supplied from an electrode PL1 and an electrode PL2."

### Citation List

### Patent Literature

PTL 1: JP-A-2001-176338

### Summary of Invention

### Technical Problem

As described in PTL 1, a superconducting magnet is often provided with a permanent current switch. However, a cost of the superconducting magnet may increase by providing the permanent current switch.

The invention has been made in view of the above circumstance, and an object thereof is to provide a superconducting magnet at a low cost, a superconducting wire material, and a production method for a superconducting magnet.

### Solution to Problem

In order to solve the above problem, a superconducting magnet according to the invention includes: a magnet portion wound with a first superconducting wire material including a superconducting material portion, a high-resistance conductor layer, and a low-resistance conductor layer having a resistance value per unit length lower than that of the high-resistance conductor layer; and a current switch including a second superconducting wire material including the superconducting material portion and the high-resistance conductor layer. The second superconducting wire material does not include the low-resistance conductor layer or includes the low-resistance conductor layer thinner than the low-resistance conductor layer in the first superconducting wire material.

### Advantageous Effect

According to the invention, it is possible to implement the superconducting magnet at a low cost, a superconducting wire material, and a production method for a superconducting magnet.

### Brief Description of Drawings

[FIG. 1] FIG. 1 is a schematic circuit diagram of a superconducting magnet according to a preferred first embodiment.
[FIG. 2] FIG. 2 is a cross-sectional diagram taken along a line II-II in FIG. 1.
[FIG. 3] FIG. 3 is a cross-sectional diagram taken along a line III-III in FIG. 1.
[FIG. 4] FIG. 4 is a schematic circuit diagram of a superconducting magnet according to a preferred second embodiment.
[FIG. 5] FIG. 5 is a diagram showing another arrangement method for a second superconducting wire material in a PCS.
[FIG. 6] FIG. 6 is a diagram showing still another arrangement method for the second superconducting wire material in the PCS.
[FIG. 7] FIG. 7 is a cross-sectional diagram of a main part of a superconducting magnet according to a preferred third embodiment.
[FIG. 8] FIG. 8 is a schematic circuit diagram of a superconducting magnet according to a preferred fourth embodiment.
[FIG. 9] FIG. 9 is a cross-sectional diagram of a superconducting wire material taken along a line IX-IX in FIG. 8.
[FIG. 10] FIG. 10 is a cross-sectional diagram of the superconducting wire material taken along a line X-X in FIG. 8.
[FIG. 11] FIG. 11 is a schematic circuit diagram of a superconducting magnet according to a preferred fifth embodiment.
[FIG. 12] FIG. 12 is a schematic circuit diagram of a superconducting magnet 110 according to a preferred sixth embodiment.

### Description of Embodiments

### [Premise of Embodiments]

A superconducting magnet using a superconducting wire material is used in magnetic resonance imaging (MRI), nuclear magnetic resonance (NMR), particle beam medical devices, and the like, and its application to electric motors or the like is also being studied daily. The superconducting magnet may be operated in a permanent current mode, in which an entire closed circuit including the superconducting magnet is made of superconductivity and a direct current continues flowing, based on a feature that no loss occurs even when a direct current flows through the superconducting wire material. In the permanent current mode, the superconducting magnet can maintain a magnetic field when no power supply that supplies a current to the superconducting magnet is connected.

In general, a permanent current mode operation is executed by a device provided with a closed circuit that connects a superconducting magnet and an excitation power supply to supply an excitation current to the superconducting magnet, and a closed circuit that connects the superconducting magnet and a persistent current switch (PCS) in a superconducting manner to flow a permanent current. That is, the excitation current may be applied from the excitation power supply to the superconducting magnet when the PCS is in a normal-conducting state, and the excitation power supply may be electrically decoupled from the superconducting magnet while the PCS is in a superconducting state when the excitation current reaches a desired value.

On the contrary, when the superconducting magnet is degaussed, the PCS is transitioned to the normal-conducting state. As for the method, for example, a method for heating the superconducting wire material with a heater or applying the magnetic field to the superconducting wire material is adopted. Time required for demagnetization depends on a time constant (= L/R) determined by an inductance L of the superconducting magnet and an electrical resistance (hereinafter simply referred to as resistance) R of the PCS in the normal-conducting state. How to set the time constant is generally determined based on a specification of a superconducting magnet application device or the like, and the PCS in the normal-conducting state is required to have a desired electrical resistance.

The resistance value of the PCS in the normal-conducting state is determined by an electrical resistivity (hereinafter, simply referred to as resistivity), a dimension of a cross section, and a length of a material forming the superconducting wire material used for the PCS. Generally, the superconducting wire material is implemented by filling a superconducting material in a tubular body made of Cu, Al, Ag, and the like, or an alloy containing these metals, or laminating these metals and the superconducting material in a tape shape. That is, the cross section of the superconducting wire material generally contains the superconducting material and the metals. The metals serve as a stabilizing material for the superconducting wire, and the metals serving as the stabilizing material are required to have a low resistance. On the other hand, since the PCS is required to have a desired electrical resistance in the normal-conducting state as described above, a length of a wire material of the PCS may be long when the PCS includes the same superconducting wire material as that of the superconducting magnet.

In order to shorten the length of the wire material of the PCS, as the superconducting wire material for PCS different from that of the superconducting magnet, there is a method for increasing a resistance per unit length by, for example, using a metal (for example, a Cu-Ni alloy) that has a high resistivity and reduces a cross-sectional area of a metal portion. Since the method is a trade-off measure with stabilization, in general, a large load margin is taken by installing the PCS in a place where the magnetic field is low and increasing the cross-sectional area of the superconducting material, thereby ensuring stability. As the metal that is in contact with the superconducting material, a metal that does not prevent a raw material of the superconducting material from reacting into a superconducting material at the time of processing the superconducting wire material is selected. According to the method, the superconducting magnet and the PCS constitute a closed circuit in which ends of the superconducting magnet and the PCS at two places are connected in the superconducting manner.

In the superconducting magnet operating in the permanent current mode, it is desirable that the superconducting magnet and the PCS are connected in the superconducting manner, a desired electrical resistance value is applied to the PCS during normal conduction, and an economical structure is implemented as an entire circuit of the superconducting magnet and the PCS. On the other hand, in a configuration to which the content of PTL 1 is applied, a part of the superconducting wire material that is a loop is wound such that a flowing current is oriented in the same direction to form the superconducting magnet, and the rest of the superconducting wire material is subjected to a non-inductive winding to form the PCS. According to the configuration, it is not necessary to provide superconducting connection between the superconducting magnet and the PCS, or that the superconducting connection can be made at one place.

In general, a high technique is required for the superconducting connection, and it is necessary to ensure handling and workability of the superconducting magnet in the application device, and thus it is more economical than the configuration in the related art that requires the superconducting connection at two places. On the other hand, since the superconducting magnet and the PCS are made of the same superconducting wire material, the length of the wire material required for the PCS is long.

Therefore, preferred embodiments to be described below are to implement a compact and lightweight PCS as compared with the PCS when the superconducting connection between the superconducting magnet and the PCS is made at one place and the superconducting wire material for PCS has the same configuration as that of the superconducting wire material of the superconducting magnet, thereby economically implementing the superconducting magnet.

### [First Embodiment]

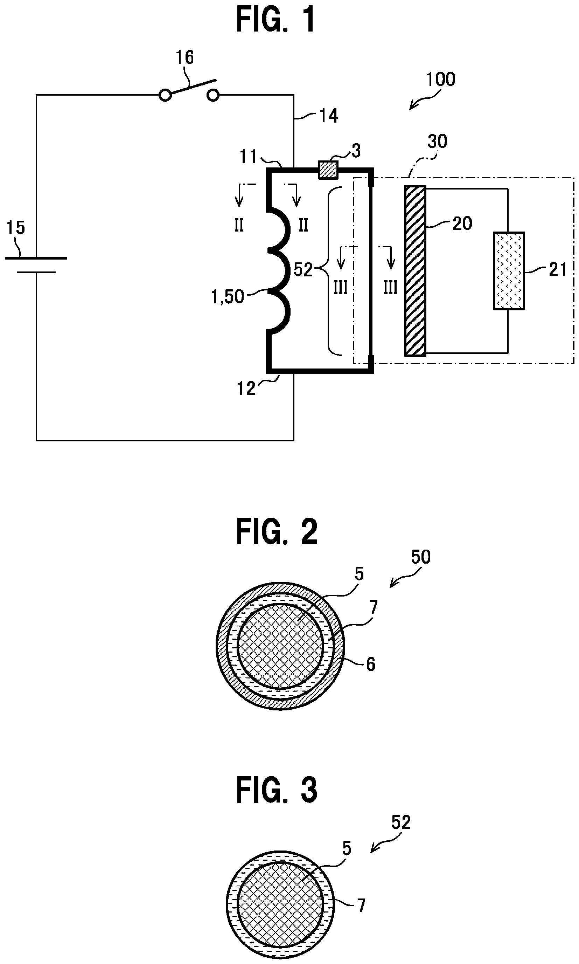

FIG. 1 is a schematic circuit diagram of a superconducting magnet 100 according to a preferred first embodiment.

In FIG. 1, the superconducting magnet 100 includes a PCS 30 (current switch), a first superconducting wire material 50 (superconducting wire material), a second superconducting wire material 52, an excitation power supply 15 (direct current power supply), and a switch 16. The first superconducting wire material 50 is wound in a coil shape to form a magnet portion 1.

The excitation power supply 15 is a direct current power supply and is connected to a starting edge 11 and a terminating edge 12 of the magnet portion 1 via the switch 16 and a lead wire 14. The connection between the lead wire 14 and the first superconducting wire material 50 may be a normal solder connection. Therefore, when the excitation power supply 15 is turned on by the switch 16, a current is supplied between the starting edge 11 and the terminating edge 12 of the magnet portion 1.

The PCS 30 is generally called a permanent current switch and includes a heating unit 20 that heats the second superconducting wire material 52 and a power supply device 21 that supplies a current to the heating unit 20. According to the present embodiment, the starting edge 11 and the terminating edge 12 of the magnet portion 1 are a starting edge and a terminating edge of the PCS 30 as they are, and the magnet portion 1 and the PCS 30 are continuously connected by the first superconducting wire material 50.

FIG. 2 is a cross-sectional diagram of the first superconducting wire material 50 taken along a line II-II in FIG. 1.

In FIG. 2, the first superconducting wire material 50 includes a superconducting material portion 5, a low-resistance conductor layer 6, and a high-resistance conductor layer 7. The low-resistance conductor layer 6 is made of Cu or a Cu-based alloy in a cylindrical shape. The high-resistance conductor layer 7 is arranged on an inner peripheral side of the low-resistance conductor layer 6, and is made of Fe or a Fe-based alloy in a cylindrical shape. In addition, the superconducting material portion 5 contains MgB₂ (magnesium diboride) as a main component, and is arranged on an inner peripheral side of the high-resistance conductor layer 7. A part of the superconducting material portion 5 may contain a substance other than a superconducting material.

FIG. 3 is a cross-sectional diagram of the second superconducting wire material 52 taken along a line III-III in FIG. 1.

In FIG. 3, the second superconducting wire material 52 is obtained by removing the low-resistance conductor layer 6 from the first superconducting wire material 50 (see FIG. 2). That is, the second superconducting wire material 52 includes the high-resistance conductor layer 7 and the superconducting material portion 5. That is, in the second superconducting wire material 52, it is not always necessary to completely remove the low-resistance conductor layer 6, and the low-resistance conductor layer 6 may remain while the low-resistance conductor layer 6 is processed thinner than the first superconducting wire material 50.

In this manner, according to the present embodiment, the second superconducting wire material 52 can be obtained by removing all or a part of the low-resistance conductor layer 6 from the first superconducting wire material 50. Therefore, the PCS 30 can be obtained in a small size and at a low cost.

When the first superconducting wire 50 is applied to, for example, a MgB₂ superconducting wire material having a diameter of about 1.6 mm, the superconducting material portion 5 may contain 25% or more (weight percent, the same applies hereinafter) of MgB₂. In addition, the high-resistance conductor layer 7 may contain 35% or more of Fe and 15% or more of SUS316L. In addition, the low-resistance conductor layer 6 may contain 25% or more of Cu.

According to a configuration of the first superconducting wire material 50 described above, at about 40K where MgB₂ is subjected to a normal conduction transition, a resistance value per unit length can be set to an order of 1 × 10⁻³ Ω/m. Further, in the second superconducting wire material 52 in which the low-resistance conductor layer 6 is removed from the first superconducting wire material 50, the resistance value per unit length can be set to an order of 1 × 10⁻² Ω/m. Therefore, when the second superconducting wire material 52 is applied to the PCS 30, a length of the wire material in the PCS 30 can be shortened to about one tenth as compared with a case where the first superconducting wire material 50 is applied to the PCS 30 as it is.

Here, when a resistance value per unit length of the low-resistance conductor layer 6 is R6 (not shown) and a resistance value per unit length of the high-resistance conductor layer 7 is R7 (not shown), a ratio R7/R6 is preferably "2" or more and less than "10¹²". A reason is that when the ratio R7/R6 is less than "2", an effect of "shortening the length of the wire material in the PCS 30" is insufficient, and when the ratio R7/R6 is "10¹²" or more, an operation of the superconducting magnet 100 is unstable. In addition, it is more preferable that the ratio R7/R6 is "10⁷" or less. A reason is that a cost of the superconducting magnet 100 can be reduced because the high-resistance conductor layer 7 can be implemented with a material that can be obtained at a low price.

When the first superconducting wire material 50 configured as described above is immersed in a concentrated nitric acid, the low-resistance conductor layer 6 containing Cu as a main component is dissolved. On the other hand, the high-resistance conductor layer 7 containing Fe as a main component forms a passivation against the concentrated nitric acid, and thus the high-resistance conductor layer 7 is hardly dissolved. That is, when a part of the first superconducting wire material 50 is immersed in the concentrated nitric acid, the immersed portion changes to the second superconducting wire material 52. However, a method for removing the low-resistance conductor layer 6 does not necessarily have to be chemical, and the low-resistance conductor layer 6 may be removed by mechanical cutting.

Returning to FIG. 1, a superconducting connection portion 3 is a place where ends of the first superconducting wire material 50 are connected while maintaining the same characteristics as the first superconducting wire material 50. As described above, according to the present embodiment, the starting edge 11 and the terminating edge 12 of the magnet portion 1 are the starting edge and the terminating edge of the PCS 30 as they are, and the magnet portion 1 and the PCS 30 are continuous. Therefore, the required superconducting connection portion 3 may be one place as shown in the drawing.

Here, a production method for the superconducting magnet 100 can be summarized as follows. An execution order of steps S2 and S3 among these steps S1, S2, and S3 may be changed.

Step S1: winding the first superconducting wire material 50 to form the magnet portion 1.

Step S2: removing (or thinning) the low-resistance conductor layer 6 at a predetermined portion other than the magnet portion 1 of the first superconducting wire material 50 to form the second superconducting wire material 52.

Step S3: joining both ends of an aggregate of the first superconducting wire material 50 and the second superconducting wire material 52 to form the aggregate in an annular shape.

According to the above configuration, when a permanent current mode operation is performed, the magnet portion 1 and the PCS 30 are set to a normal-conducting state, and with the switch 16 turned on, an excitation current flows through the magnet portion 1. Next, the magnet portion 1 and the PCS 30 are cooled to a superconducting state, and when the excitation current reaches a desired value, the switch 16 is turned off. Therefore, a current is continuously recirculated between the magnet portion 1 and the PCS 30.

Thereafter, when the magnet portion 1 is degaussed, a current is supplied to the heating unit 20 by the power supply device 21. Thus, the heating unit 20 heats the second superconducting wire material 52 to transition to the normal-conducting state. Therefore, a current recirculating in the magnet portion 1 and the PCS 30 is zero.

### [Second Embodiment]

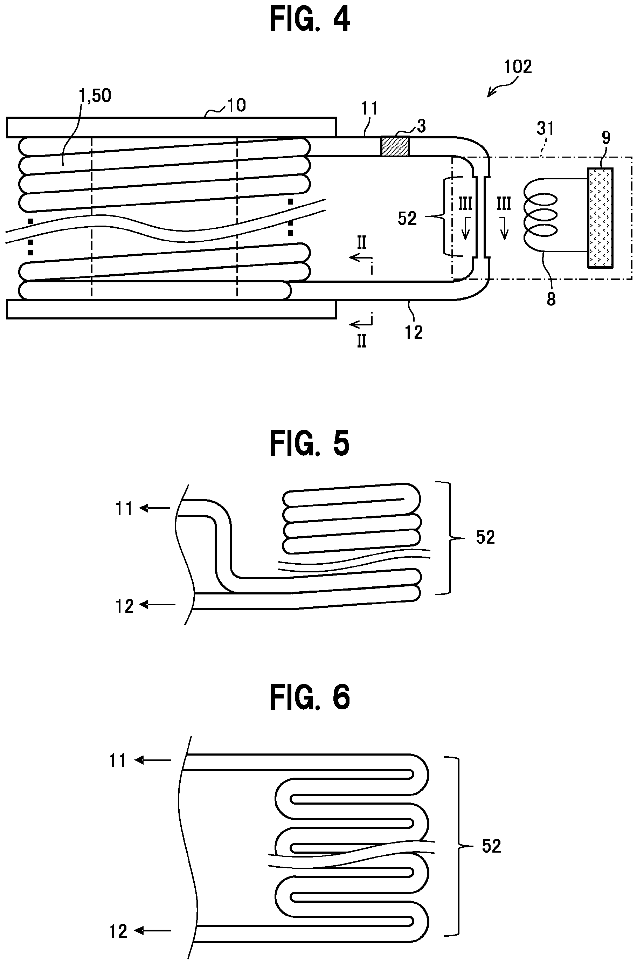

FIG. 4 is a schematic circuit diagram of a superconducting magnet 102 according to a preferred second embodiment. In the following description, the same reference numerals may be given to portions corresponding to the respective portions of the first embodiment described above, and the description thereof may be omitted.

In FIG. 4, the superconducting magnet 102 includes a winding bobbin 10, a PCS 31 (current switch), the first superconducting wire material 50, and the second superconducting wire material 52. The magnet portion 1 is obtained by winding the first superconducting wire material 50 around the winding bobbin 10.

In addition, although not shown in FIG. 4, according to the present embodiment, the excitation power supply 15 is connected to the switch 16 and the lead wire 14 in the same manner as in the first embodiment (see FIG. 1) between the starting edge 11 and the terminating edge 12 of the magnet portion 1. The starting edge 11 and the terminating edge 12 of the magnet portion 1 are a starting edge and a terminating edge of the PCS 31 as they are, and the magnet portion 1 and the PCS 31 are continuous. The PCS 31 in the present embodiment includes a heater 8 that heats the second superconducting wire material 52, and a heater power supply 9 that supplies a current to the heater 8.

The heater 8 is obtained by flowing a current through a metal (for example, Cu-Ni) having a high resistance to generate heat. The second superconducting wire material 52 is arranged in a straight-line shape inside the PCS 31. When the length of the second superconducting wire material 52 is small, as shown in FIG. 2, the second superconducting wire material 52 may be arranged simply in the straight-line shape. However, when the second superconducting wire material 52 requires a certain length, it is preferable to wind or bend the second superconducting wire material 52 in order to save space. For example, a bobbin or jig (not shown) for the PCS 31 may be arranged at a position different from the bobbin 10 of the magnet portion 1, and the second superconducting wire material 52 may be wound around the bobbin or jig (not shown). In that case, it is preferable to arrange the second superconducting wire material 52 so as to reduce an inductance. An example thereof will be described with reference to FIGS. 5 and 6.

FIGS. 5 and 6 are diagrams showing other arrangement methods for the second superconducting wire material 52 in the PCS 31.

In FIG. 5, the second superconducting wire material 52 is obtained by non-inductive winding. In FIG. 6, the second superconducting wire material 52 is arranged in a meander shape. In either one of the arrangement methods of FIGS. 5 and 6, the inductance of the second superconducting wire material 52 can be reduced.

According to the present embodiment, similar to the first embodiment described above, the superconducting connection portion 3 can be in one place, and the PCS 31 can be obtained in a small size and at a low cost.

### [Third Embodiment]

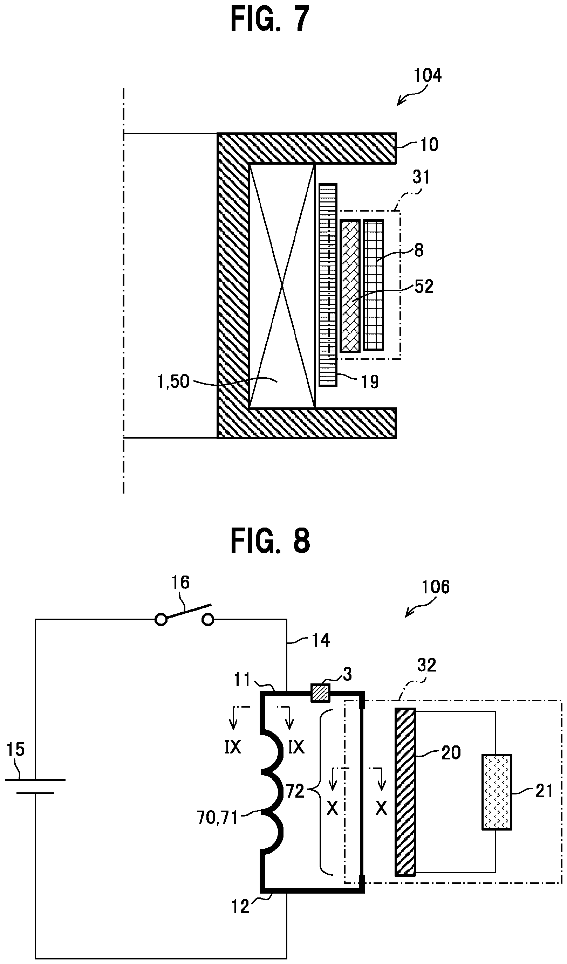

FIG. 7 is a cross-sectional diagram of a main part of a superconducting magnet 104 according to a preferred third embodiment. In the following description, the same reference numerals may be given to portions corresponding to the portions of the other embodiments described above, and the description thereof may be omitted.

In FIG. 7, the superconducting magnet 104 includes the winding bobbin 10, the PCS 31, the first superconducting wire material 50, and the second superconducting wire material 52. Further, although not shown in the drawing, the superconducting magnet 104 includes the excitation power supply 15 (see FIG. 1) and the switch 16 (see FIG. 1), similarly to the superconducting magnet 100 according to the first embodiment.

According to the present embodiment, the first superconducting wire material 50 is wound around the bobbin 10 to form the magnet portion 1. In addition, the PCS 31 includes the second superconducting wire material 52 and the heater 8. However, in the present embodiment, the PCS 31 is arranged close to the magnet portion 1, and a heat insulating layer 19 is inserted between the PCS 31 and the magnet portion 1. A configuration and an operation of the superconducting magnet 104 other than those described above are the same as those of the superconducting magnet 102 (see FIG. 4) according to the second embodiment. As described above, according to the present embodiment, since the magnet portion 1 and the PCS 31 can be arranged close to each other, there is an advantage that the superconducting magnet 104 can be miniaturized.

### [Fourth Embodiment]

FIG. 8 is a schematic circuit diagram of a superconducting magnet 106 according to a preferred fourth embodiment. In the following description, the same reference numerals may be given to portions corresponding to the portions of the other embodiments described above, and the description thereof may be omitted.

In FIG. 8, the superconducting magnet 106 includes a PCS 32 (current switch), a first superconducting wire material 70 (superconducting wire material), a second superconducting wire material 72, the excitation power supply 15, and the switch 16. Then, the first superconducting wire material 70 is wound in a coil shape to form a magnet portion 71. Functions of the excitation power supply 15 and the switch 16 are the same as those of the first embodiment (see FIG. 1).

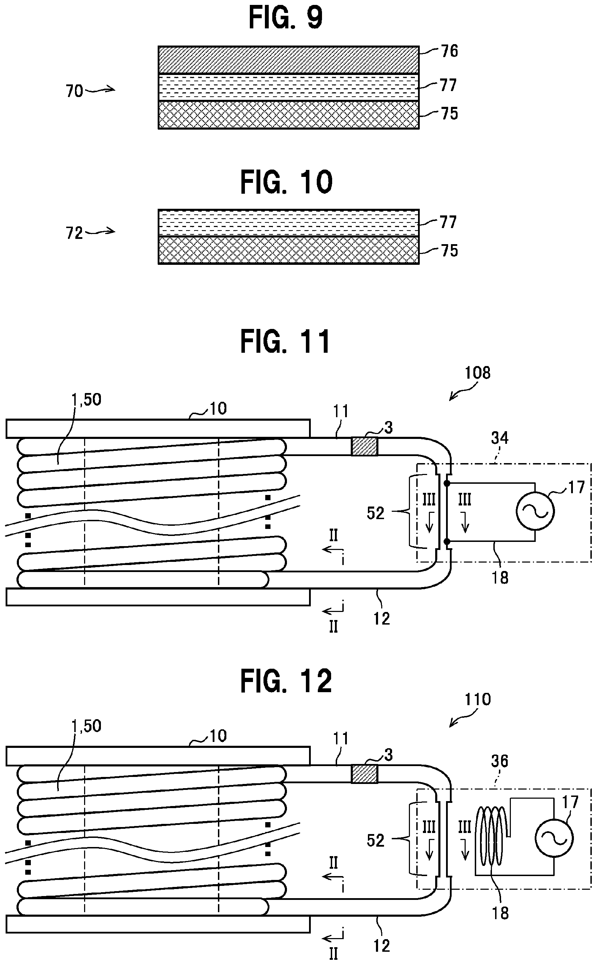

FIG. 9 is a cross-sectional diagram of the first superconducting wire material 70 taken along a line IX-IX in FIG. 8.

In FIG. 9, the first superconducting wire material 70 includes a superconducting material portion 75, a low-resistance conductor layer 76, and a high-resistance conductor layer 77 that are sequentially laminated. These materials are formed in a tape shape having a rectangular cross section, and these materials are the same as those of the superconducting material portion 5, the low-resistance conductor layer 6, and the high-resistance conductor layer 7 according to the first embodiment (see FIG. 2).

FIG. 10 is a cross-sectional diagram of the second superconducting wire material 72 taken along a line X-X in FIG. 8.

The second superconducting wire material 72 is obtained by removing the low-resistance conductor layer 76 from the first superconducting wire material 70. That is, the second superconducting wire material 72 includes the superconducting material portion 75 and the high-resistance conductor layer 77. As in the case of the first embodiment, in the second superconducting wire material 72 as well, it is not necessary to completely remove the low-resistance conductor layer 76, and the low-resistance conductor layer 76 may remain while the low-resistance conductor layer 76 is processed thinner than the first superconducting wire material 70. In addition, a plurality of the first superconducting wire materials 70 or a plurality of the second superconducting wire materials 72 may be bundled in a parallel conductor shape to form the magnet portion 71 or the PCS 32.

As described above, according to the present embodiment, the second superconducting wire material 72 can be obtained by removing all or a part of the low-resistance conductor layer 76 from the first superconducting wire material 70. Therefore, as in the first embodiment, the PCS 32 can be obtained in a small size and at a low cost. The configurations and operations of the present embodiment other than those described above are the same as those of the first embodiment (see FIGS. 1 to 3).

### [Fifth Embodiment]

FIG. 11 is a schematic circuit diagram of a superconducting magnet 108 according to a preferred fifth embodiment. In the following description, the same reference numerals may be given to portions corresponding to the portions of the other embodiments described above, and the description thereof may be omitted.

In FIG. 11, a superconducting magnet 108 is different from the superconducting magnet 102 according to the second embodiment (see FIG. 4) in that a PCS 34 is applied instead of the PCS 31. In other points, the superconducting magnet 108 has the same configuration as the superconducting magnet 102. Therefore, the configurations of the first superconducting wire material 50 and the second superconducting wire material 52 are the same as those shown in FIGS. 2 and 3.

In addition, as in the example shown in FIG. 7, the PCS 34 may be arranged with the heat insulating layer 19 inserted between the magnet portion 1 and the PCS 34. The PCS 34 includes the second superconducting wire material 52 and an alternate current power supply 17. Further, the alternate current power supply 17 is connected to the high-resistance conductor layer 7 (see FIG. 3) of the second superconducting wire material 52.

In the above configuration, an operation when a permanent current mode operation is performed is the same as that of the first embodiment. On the other hand, when the magnet portion 1 is degaussed, the alternate current power supply 17 applies a predetermined alternate current voltage to the second superconducting wire material 52. Since an inductance of the magnet portion 1 is sufficiently larger than the inductance of the second superconducting wire material 52, most of the current supplied from the alternate current power supply 17 flows through the second superconducting wire material 72. Therefore, the second superconducting wire material 72 functions as a heater to transition the second superconducting wire material 52 to the normal-conducting state, and the current recirculating in the magnet portion 1 and the PCS 34 is zero.

Specifically, it is assumed that the high-resistance conductor layer 7 (see FIG. 3) is a Fe-based alloy, a resistivity is 1.5 × 10⁻² [µΩm], and a frequency of the alternate current voltage is 1 MHz. In this case, a skin depth is 6 × 10⁻² [mm], and most of the current flowing through the second superconducting wire material 52 can flow through the high-resistance conductor layer 7.

### [Sixth Embodiment]

FIG. 12 is a schematic circuit diagram of a superconducting magnet 110 according to a preferred sixth embodiment. In the following description, the same reference numerals may be given to portions corresponding to the portions of the other embodiments described above, and the description thereof may be omitted.

In FIG. 11, the superconducting magnet 108 is different from the superconducting magnet 102 according to the second embodiment (see FIG. 4) in that a PCS 36 is applied instead of the PCS 31. In other points, the superconducting magnet 110 has the same configuration as the superconducting magnet 102.

The PCS 36 includes the second superconducting wire material 52, an electromagnet 18 (an alternate current magnetic field generation unit), and the alternate current power supply 17. Further, the electromagnet 18 is arranged at a position close to the second superconducting wire material 52.

In the above configuration, an operation when a permanent current mode operation is performed is the same as that of the first embodiment. On the other hand, when the magnet portion 1 is degaussed, the alternate current power supply 17 applies a predetermined alternate current voltage to the electromagnet 18. Thus, the electromagnet 18 generates the alternate current magnetic field in the high-resistance conductor layer 7 (see FIG. 3) of the second superconducting wire material 52, and an eddy current is generated in the high-resistance conductor layer 7. Therefore, the high-resistance conductor layer 7 generates heat to transition the second superconducting wire material 52 to the normal-conducting state, and the current recirculating in the magnet portion 1 and the PCS 34 is zero. Further, since there is an effect that the above-mentioned alternate current magnetic field reduces a critical current of the superconducting material portion 5 (see FIG. 3), this effect may also be used for a normal conduction transition of the second superconducting wire material 52.

### [Effect of Embodiments]

According to the preferred embodiments as described above, the superconducting magnets 100 to 110 include: the magnet portions 1, 71 wound with the first superconducting wire materials 50, 70 including the superconducting material portions 5, 75, the high-resistance conductor layers 7, 77, and the low-resistance conductor layer 6, 76 having a resistance value per unit length lower than that of the high-resistance conductor layers 7, 77; and the current switches 30, 36 including the second superconducting wire materials 52, 72 including the superconducting material portions 5, 75 and the high-resistance conductor layers 7, 77. The second superconducting wire materials 52, 72 do not include the low-resistance conductor layers 6, 76 or include the low-resistance conductor layers 6, 76 thinner than the low-resistance conductor layers 6, 76 in the first superconducting wire materials 50, 70. As described above, the second superconducting wire materials 52, 72 can be obtained by removing the low-resistance conductor layers 6, 76 from the first superconducting wire materials 50, 70, and the superconducting magnets 100 to 110 can be obtained at a low cost.

In addition, it is more preferable that the current switch 31 includes the heater 8 that heats the second superconducting wire material 52. Therefore, when the magnet portion 1 is degaussed, the heater 8 can transition the second superconducting wire material 52 to the normal-conducting state.

In addition, it is more preferable that the current switch 34 includes the alternate current power supply 17 that applies the alternate current voltage to the high-resistance conductor layer 7 of the second superconducting wire material 52. Therefore, the current flows through the high-resistance conductor layer 7, and thus the high-resistance conductor layer 7 generates heat to transition the second superconducting wire material 52 to the normal-conducting state.

In addition, it is more preferable that the current switch 36 includes the alternate current magnetic field generation unit 18 that generates the eddy current in the high-resistance conductor layer 7 of the second superconducting wire material 52 by generating the alternate current magnetic field. Therefore, the high-resistance conductor layer 7 generates heat due to the eddy current to transition the second superconducting wire material 52 to the normal-conducting state.

In addition, it is more preferable that the superconducting material portions (5, 75) contain MgB₂. Therefore, the superconducting material portions 5, 75 having a high transition temperature can be manufactured at a low cost.

In addition, it is more preferable that the low-resistance conductor layer 6 is made of Cu or a Cu-based alloy in a cylindrical shape, that the high-resistance conductor layer 7 is arranged on the inner peripheral side of the low-resistance conductor layer 6 and is made of Fe or a Fe-based alloy in a cylindrical shape, and that the superconducting material portion 5 is arranged on the inner peripheral side of the high-resistance conductor layer 7. Therefore, the low-resistance conductor layer 6 can be arranged on an outermost periphery, and the low-resistance conductor layer 6 can be easily removed when the second superconducting wire material 52 is formed.

In addition, it is more preferable that the superconducting magnets 100 to 110 further include the direct current power supply (15) that supplies the current to the first superconducting wire material 50, and the switch 16 that is inserted between the direct current power supply (15) and the first superconducting wire material 50. Therefore, the current can be recirculated between the magnet portion 1 and the PCS 30 by the switch 16 and the direct current power supply (15).

In addition, it is more preferable that the resistance value per unit length of the high-resistance conductor layers 7, 77 is twice or more and less than 10¹² times the resistance value per unit length of the low-resistance conductor layers 6, 76. Therefore, the length of the wire material of the second superconducting wire materials 52, 72 in the current switches (30 to 36) can be sufficiently shortened while stabilizing the operation of the superconducting magnets 100 to 110.

In addition, it is more preferable that the low-resistance conductor layers 6, 76 have a property of being dissolved by a predetermined treatment agent, and the high-resistance conductor layers 7, 77 have a property of not being dissolved by the treatment agent or being less likely to dissolve than the low-resistance conductor layers 6, 76. Therefore, the second superconducting wire materials 52, 72 can be easily formed by removing the low-resistance conductor layers 6, 76 from the first superconducting wire materials 50, 70 by the treatment agent.

### [Modifications]

The invention is not limited to the above-described embodiments, and various modifications can be made. The above-described embodiments are shown to facilitate understanding of the invention, and are not necessarily limited to those having all the configurations described above. In addition, a part of a configuration of one embodiment can be replaced with a configuration of another embodiment, and the configuration of the other embodiment can also be added to the configuration of the one embodiment. In addition, a part of the configuration of each embodiment can be deleted, added to, or replaced with another configuration. Further, control lines and information lines shown in the drawings are considered to be necessary for the description, and all control lines and information lines required on the product are not necessarily shown. It may be considered that almost all the configurations are actually connected to each other. The modifications that can be applied to the above-described embodiments are, for example, as follows.
(1) According to the above embodiments, the low-resistance conductor layers 6, 76 have the property of being dissolved by the predetermined treatment agent (that is, the concentrated nitric acid), and the high-resistance conductor layers 7, 77 have the property of not being dissolved by the treatment agent (or being less likely to dissolve than the low-resistance conductor layers 6, 76) . Since there are many combinations of the low-resistance conductor layers 6, 76, the high-resistance conductor layers 7, 77, and the treatment agent that have such chemical properties, the invention is not limited to those described in the above embodiments.
(2) In each of the above embodiments, an example in which the invention is applied to a superconducting magnet has been described. Alternatively, only the first superconducting wire materials 50, 70 may be distributed independently.

### Reference Sign List

1, 71 magnet portion
5, 75 superconducting material portion
6, 76 low-resistance conductor layer
7, 77 high-resistance conductor layer
8 heater
15 excitation power supply (direct current power supply)
16 switch
17 alternate current power supply
18 electromagnet (alternate current magnetic field generation unit)
30 to 36 PCS (current switch)
50, 70 first superconducting wire material (superconducting wire material)
52, 72 second superconducting wire material
100 to 110 superconducting magnet

## Claims

1. A superconducting magnet comprising:
a magnet portion wound with a first superconducting wire material including a superconducting material portion, a high-resistance conductor layer, and a low-resistance conductor layer having a resistance value per unit length lower than that of the high-resistance conductor layer; and
a current switch including a second superconducting wire material including the superconducting material portion and the high-resistance conductor layer, wherein
the second superconducting wire material does not include the low-resistance conductor layer or includes the low-resistance conductor layer thinner than the low-resistance conductor layer in the first superconducting wire material.

2. The superconducting magnet according to claim 1, wherein
the current switch includes a heater that heats the second superconducting wire material.

3. The superconducting magnet according to claim 1, wherein
the current switch includes an alternate current power supply that applies an alternate current voltage to the high-resistance conductor layer of the second superconducting wire material.

4. The superconducting magnet according to claim 1, wherein
the current switch includes an alternate current magnetic field generation unit that generates an eddy current in the high-resistance conductor layer of the second superconducting wire material by generating an alternate current magnetic field.

5. The superconducting magnet according to any one of claims 1 to 4, wherein
the superconducting material portion contains MgB₂.

6. The superconducting magnet according to claim 5, wherein
the low-resistance conductor layer is made of Cu or a Cu-based alloy in a cylindrical shape,
the high-resistance conductor layer is arranged on an inner peripheral side of the low-resistance conductor layer, and is made of Fe or a Fe-based alloy in a cylindrical shape, and
the superconducting material portion is arranged on an inner peripheral side of the high-resistance conductor layer.

7. The superconducting magnet according to claim 1, further comprising:
a direct current power supply configured to supply a current to the first superconducting wire material; and
a switch inserted between the direct current power supply and the first superconducting wire material.

8. The superconducting magnet according to claim 1, wherein
the resistance value per unit length of the high-resistance conductor layer is twice or more and less than 10¹² times the resistance value per unit length of the low-resistance conductor layer.

9. The superconducting magnet according to claim 8, wherein
the low-resistance conductor layer has a property of being dissolved by a predetermined treatment agent, and
the high-resistance conductor layer has a property of not being dissolved by the treatment agent or being less likely to dissolve than the low-resistance conductor layer.

10. A superconducting wire material comprising:
a superconducting material portion;
a high-resistance conductor layer; and
a low-resistance conductor layer having a resistance value per unit length lower than that of the high-resistance conductor layer, wherein
the resistance value per unit length of the high-resistance conductor layer is twice or more and less than 10¹² times the resistance value per unit length of the low-resistance conductor layer.

11. A production method for a superconducting magnet, the method comprising:
forming a magnet portion wound with a first superconducting wire material including a superconducting material portion, a high-resistance conductor layer, and a low-resistance conductor layer having a resistance value per unit length lower than that of the high-resistance conductor layer;
removing or thinning the low-resistance conductor layer at a portion other than the magnet portion of the first superconducting wire material to form a second superconducting wire material; and
joining both ends of an aggregate of the first superconducting wire material and the second superconducting wire material to form the aggregate in an annular shape.
